# EUROPÄISCHE PATENTSCHRIFT

(11) **EP 1 966 619 B1**
(45) Veröffentlichungstag und Bekanntmachung des Hinweises auf die Patenterteilung: **18.01.2012**
(21) Anmeldenummer: 06829474.3
(22) Anmeldetag: 09.12.2006
(51) Int. Cl.: G01R 31/36

(54) **ENTLADEZUSTANDSANZEIGE**
DISCHARGE STATE INDICATOR
VISUALISATION D UN ÉTAT DE DÉCHARGE

(30) Priorität: 29.12.2005 DE 102005063045
(43) Veröffentlichungstag der Anmeldung: 10.09.2008
(73) Patentinhaber: Braun GmbH, 61476 Kronberg (DE)
(72) Erfinder: KLEMM, Torsten, 65812 Bad Soden (DE); RÖNNEBERG, Gerrit, 64289 Darmstadt (DE)
(86) Internationale Anmeldenummer: PCT/EP2006/011882
(87) Internationale Veröffentlichungsnummer: WO 2007/079868

(56) Entgegenhaltungen:
- EP-A2- 0 712 007
- WO-A-01/78211
- DE-A1- 19 911 590
- JP-A- 11 187 471
- US-A1- 4 019 112
- US-A1- 4 703 247

## Beschreibung

Die Erfindung betrifft eine Schaltung zum Anzeigen des entladenen Zustands einer Batterie, bei dem die Spannung der Batterie unter einen bestimmten Schwellwert abgefallen ist, wobei die Schaltung vorzugsweise für batteriebetriebene Elektrokleingeräte mit einem induktiven Verbraucher gedacht ist.

Aus der DE 36 22 991 A1 ist eine derartige Schaltung mit einer Leuchtdiodenanzeige bekannt, die für batteriebetriebene Geräte gedacht ist, deren Batteriespannung zum Betreiben der Leuchtdiode nicht ausreicht. Diese Schaltung enthält eine Reihenschaltung aus der Batterie, einer Drossel und der Kollektor-Emitter-Strecke eines Transistors. Die Leuchtdiode liegt parallel zur Kollektor-Emitter-Strecke des Transistors. Ist die Batteriespannung kleiner als ein bestimmter Referenzwert, wird die Basis des Transistors periodisch angesteuert, sodaß der Transistor abwechselnd leitet und sperrt, und daher ein pulsierender Strom durch die Drossel fließt, dessen Takt durch ein RC-Glied bestimmt wird. Beim Sperren des Transistors wird in der Drossel eine Spannung induziert, die sich zur Batteriespannung addiert, sodaß die Durchflußspannung der Leuchtdiode erreicht wird, und diese leuchtet.

Der Erfindung liegt die Aufgabe zugrunde, eine Schaltung zum Anzeigen eines Entladezustands einer Batterie zu schaffen, die besonders wenige Bauteile aufweist, und daher besonders preisgünstig ist und wenig Platz beansprucht.

Diese Aufgabe wird durch eine Schaltung nach Anspruch 1 gelöst. Die Schaltung weist vorzugsweise eine Steuerschaltung mit einem Komparator auf, der die Spannung der Batterie mit dem ersten Schwellwert und dem zweiten Schwellwert vergleicht, und den steuerbaren Schalter entsprechend ansteuert.

Die erfindungsgemäße Schaltung macht sich die Auswirkungen des Innenwiderstands einer Batterie zunutze, der für eine Abnahme der Spannung der Batterie sorgt, wenn der der Batterie entnommene Strom ansteigt. Sie ist vorzugsweise für batteriebetriebene Elektrokleingeräte mit einem induktiven Verbraucher gedacht, der einen höheren Stromverbrauch hat als eine Anzeigevorrichtung zur Anzeige des fast entladenen Zustands der Batterie, und die Spannung der Batterie zumindest im fast entladenen Zustand zu klein ist, um die Anzeigevorrichtung zu betreiben. Beispiele für derartige Elektrokleingeräte sind elektrische Rasierapparate oder elektrische Zahnbürsten, die als induktiven Verbraucher einen Elektromotor sowie eine Batterie mit nur einer Zelle aufweisen, deren Spannung in der Regel zu klein ist, um eine Leuchtdiode zu betreiben, die einem Benutzer den fast entladenen Zustand der Batterie anzeigen soll.

Zum Erzeugen einer für den Betrieb der Leuchtdiode genügend hohen Spannung arbeitet die Schaltung ähnlich wie ein an sich bekannter Drosselwandler, wobei als Drossel der induktive Verbraucher des Elektrokleingeräts genutzt wird, um Bauteile und Kosten zu sparen. Wenn die Batterie des Elektrokleingeräts durch den Betrieb des induktiven Verbrauchers so weit entladen ist, daß ihre Spannung kleiner ist als ein erster Schwellwert, wird der induktive Verbraucher durch Öffnen des steuerbaren Schalters abgeschaltet. Dadurch wird im induktiven Verbraucher eine Spannung induziert, die sich zur Spannung der Batterie addiert und zum Betreiben der Leuchtdiode ausreicht. Da die Leuchtdiode einen kleineren Stromverbrauch hat als der induktive Verbraucher, erholt sich die Batterie, d.h. ihre Spannung steigt auf einen Wert an, der größer ist als ein zweiter Schwellwert. Daraufhin wird der steuerbare Schalter geschlossen, wodurch die Leuchtdiode erlischt, weil die induzierte Spannung zusammenbricht. Gleichzeitig wird die Batterie durch den induktiven Verbraucher wieder so stark belastet, daß ihre Spannung unter den ersten Schwellwert absinkt, woraufhin sich der oben beschriebene Vorgang solange wiederholt, bis die Batterie so weit entladen ist, daß nach Öffnen des steuerbaren Schalters die Spannung der Batterie nicht mehr auf einen Wert ansteigt, der größer ist als der zweite Schwellwert. In diesem Fall bleibt der steuerbare Schalter geöffnet, d.h. der induktive Verbraucher ist abgeschaltet, und die Batterie vor Tiefentladung geschützt.

Der steuerbare Schalter wird durch eine Steuerschaltung gesteuert, die vorzugsweise durch eine sogenannte Supervisory realisiert ist. Eine Supervisory ist ein kostengünstiges Standardbauelement, das einen Komparator und eine Schaltung zum Erzeugen einer Referenzspannung enthält. Unterschreitet die Versorgungsspannung der Supervisory diese Referenzspannung, schaltet der Ausgang des Komparators auf LOW. Steigt die Versorgungsspannung auf einen Wert an, der um eine sogenannte Hysteresisspannung größer ist als die Referenzspannung, schaltet der Ausgang des Komparators mit einer gewissen Verzögerung auf HIGH. Diese Verzögerungszeit ist durch die Geschwindigkeit der Supervisory beim Vergleichen der Batteriespannung mit dem Schwellwert vorgegeben und kann erforderlichenfalls durch eine zusätzliche Totzeit verlängert werden, die nach Bedarf einstellbar ist.

Im Unterschied zum oben erwähnten Stand der Technik weist die erfindungsgemäße Schaltung also kein RC-Glied auf, das das abwechselnde Ein- und Ausschalten des induktiven Verbrauchers bestimmt, sondern die Taktfrequenz wird durch die Erholungszeit der Batterie, die Verzögerungszeit und den Abstand zwischen dem ersten und zweiten Schwellwert, d.h. die Hysteresisspannung bestimmt. Bei einer Variante der erfindungsgemäßen Schaltung ist der erste Schwellwert gleich groß wie der zweite Schwellwert. Die Taktfrequenz wird in diesem Fall ebenfalls durch die Erholungszeit der Batterie und die Verzögerungszeit bestimmt. Die Taktfrequenz und demzufolge auch die Helligkeit der Leuchtdiode hängen auch vom Innenwiderstand der Batterie ab, der bei entladener Batterie größer ist als bei aufgeladener Batterie.

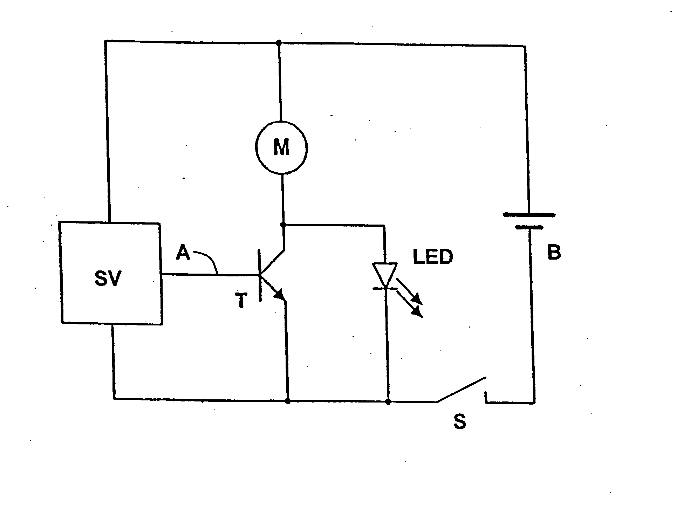

Die Erfindung wird nachfolgend anhand eines Ausführungsbeispiels für ein Elektrokleingetät erläutert, dessen Schaltung in der einzigen Figur dargestellt ist.

Die in der Figur dargestellte Schaltung umfasst eine Reihenschaltung mit einer Batterie B, einem Elektromotor M, der Kollektor-Emitter-Strecke eines Transistors T und einem mechanischen Schalter S, der zum Ein- und Ausschalten des Elektrokleingeräts dient. Eine Leuchtdiode LED ist parallel zur Kollektor-Emitter-Strecke des Transistors T geschaltet. An die Batterie B ist eine Supervisory SV angeschlossen, deren Ausgang A mit der Basis des Transistors T verbunden ist.

Unterschreitet die Spannung der Batterie einen ersten Schwellwert, steuert die Supervisory SV den Transistor T an, und schaltet dadurch den Elektromotor M ab. Dadurch kann sich die Batterie B erholen, d.h. die Spannung der Batterie B steigt an. Überschreitet die Spannung der Batterie B einen zweiten Schwellwert, der um die Hysteresisspannung der Supervisory größer ist als der erste Schwellwert, schaltet die Supervisory SV nach einer Verzögerungszeit über den Transistor T den Elektromotor M wieder ein. Sinkt daraufhin die Spannung der Batterie B wieder unter den ersten Schwellwert ab, wiederholt sich der beschriebene Vorgang mit einer bestimmten Taktfrequenz. Die Taktfrequenz kann durch eine geeignete Dimensionierung der Verzögerungszeit und der Hysteresisspannung der Supervisory SV eingestellt werden. Die Schaltung ist so dimensioniert, daß jedesmal nach dem Abschalten des Elektromotors M eine genügend hohe Spannung induziert wird, die die Leuchtdiode LED zum Leuchten bringt, d.h. die Leuchtdiode flimmert oder blinkt mit der Taktfrequenz.

Ist die Batterie B so weit entladen, daß die Spannung der Batterie B nach dem Abschalten des Elektromotors M nicht mehr auf einen Wert ansteigt, der größer ist als der zweite Schwellwert, bleibt der Transistor T geöffnet, d.h. der Elektromotor M bleibt selbst dann abgeschaltet, wenn der mechanische Schalter S geschlossen ist, wodurch die Batterie B vor Tiefentladung geschützt ist.

## Patentansprüche

1. Schaltung zum Anzeigen des entladenen Zustands einer Batterie, bei dem die Spannung der Batterie unter einen bestimmten Schwellwert abgefallen ist, wobei die Schaltung einen induktiven Verbraucher (M), einen steuerbaren Schalter (T), einen Steuerschaltung (SV) und ein Anzeigeelement (LED) enthält, wobei in einer ersten Reihenschaltung die Batterie (B), der induktive Verbraucher (M) und der steuerbare Schalter (T) in Reihe geschaltet sind, wobei in einer zweiten Reihenschaltung die Batterie (B), der induktive Verbraucher (M) und das Anzeigeelement (LED) in Reihe geschaltet sind, und wobei die Steuerschaltung (SV) den steuerbaren Schalter (T) öffnet, wenn die Spannung der Batterie (B) kleiner ist als ein erster Schwellwert, **dadurch gekennzeichnet**, daβ die Steuerschaltung (SV) den steuerbaren Schalter (T) schließt, wenn die Spannung der Batterie (B) größer ist als ein zweiter Schwellwert.

2. Schaltung nach Anspruch 1, **dadurch gekennzeichnet, daß** die Steuerschaltung (SV) einen Komparator aufweist, der die Spannung der Batterie (B) mit einem bestimmten Schwellwert vergleicht.

3. Schaltung nach Anspruch 1 oder 2, **dadurch gekennzeichnet, daß** der erste Schwellwert gleich groß ist wie der zweite Schwellwert.

4. Schaltung nach einem der vorhergehenden Ansprüche, **dadurch gekennzeichnet, daß** der induktive Verbraucher (M) ein Elektromotor ist.

5. Schaltung nach einem der vorhergehenden Ansprüche, **dadurch gekennzeichnet, daß** das Anzeigeelement (LED) eine Leuchtdiode ist.

6. Elektrischer Rasierapparat mit einer Schaltung zum Anzeigen des entladenen Zustands einer Batterie nach einem der vorhergehenden Ansprüche.

7. Elektrische Zahnbürste mit einer Schaltung zum Anzeigen des entladenen Zustands einer Batterie nach einem der Ansprüche 1 bis 5.

## Claims

1. A circuit to display the discharged state of a battery in which the voltage of the battery has fallen below a specific threshold, wherein the circuit comprises an inductive load (M), a controllable switch (T), a control circuit (SV), and a display element (LED), wherein the battery (B), the inductive load (M) and the controllable switch (T) are connected in series in a first series circuit, wherein the battery (B), the inductive load (M), and the display element (LED) are connected in series in a second series circuit, and wherein the control circuit (SV) opens the controllable switch (T) when the voltage of the battery (B) is less than a first threshold,
**characterized in that**
the control circuit (SV) closes the controllable switch (T) when the voltage of the battery (B) is greater than a second threshold.

2. The circuit according to claim 1, **characterized in that** the control circuit (SV) has a comparator that compares the voltage of the battery (B) with a defined threshold.

3. The circuit according to claim 1 or 2, **characterized in that** the first threshold is equal in size to the second threshold.

4. The circuit according to any one of the preceding claims, **characterized in that** the inductive load (M) is an electric motor.

5. The circuit according to any one of the preceding claims, **characterized in that** the display element (LED) is a light-emitting diode.

6. An electric shaving apparatus with a circuit to display the discharged state of a battery according to any one of the preceding claims.

7. An electric toothbrush with a circuit to display the discharged state of a battery according to any one of the claims 1 through 5.

## Revendications

1. Circuit d'affichage d'un état de décharge d'une batterie, où la tension de la batterie est tombée au-dessous d'une certaine valeur seuil, le circuit incluant un consommateur inductif (M), un interrupteur commandable (T), un circuit de commande (SV) et un élément d'affichage (LED), la batterie (B), le consommateur inductif (M) et l'interrupteur commandable (T) étant montés en série dans un premier montage en série,
la batterie (B), le consommateur inductif (M) et l'élément d'affichage (LED) étant montés en série dans un second montage en série, et le circuit de commande (SV) ouvrant l'interrupteur commandable (T) lorsque la tension de la batterie (B) est inférieure à une première valeur seuil, **caractérisé en ce que** le circuit de commande (SV) ferme l'interrupteur commandable (T) lorsque la tension de la batterie (B) est supérieure à une seconde valeur seuil.

2. Circuit selon la revendication 1, **caractérisé en ce que** le circuit de commande (SV) présente un comparateur qui compare la tension de la batterie (B) à une certaine valeur seuil.

3. Circuit selon la revendication 1 ou 2, **caractérisé en ce que** la première valeur seuil est identique à la seconde valeur seuil.

4. Circuit selon l'une des revendications précédentes, **caractérisé en ce que** le consommateur inductif (M) est un moteur électrique.

5. Circuit selon l'une des revendications précédentes, **caractérisé en ce que** l'élément d'affichage (LED) est une diode électroluminescente.

6. Rasoir électrique doté d'un circuit d'affichage de l'état de décharge d'une batterie selon l'une des revendications précédentes.

7. Brosse à dents électrique dotée d'un circuit d'affichage de l'état de décharge d'une batterie selon l'une des revendications 1 à 5.
